# EUROPEAN PATENT SPECIFICATION

(11) **EP 3 010 053 B1**
(45) Date of publication and mention of the grant of the patent: **01.09.2021**
(21) Application number: 14811492.9
(22) Date of filing: 13.06.2014
(51) Int. Cl.: H01L 51/42, H01L 51/48

(54) **ORGANIC PHOTOVOLTAIC CELL AND METHOD FOR MANUFACTURING SAME**
ORGANISCHE FOTOVOLTAISCHE ZELLE UND VERFAHREN ZUR HERSTELLUNG DAVON
CELLULE PHOTOVOLTAÏQUE ORGANIQUE ET SON PROCÉDÉ DE FABRICATION

(30) Priority: 14.06.2013 KR 20130068543
(43) Date of publication of application: 20.04.2016
(73) Proprietor: LG Chem, Ltd., Seoul 150-721 (KR)
(72) Inventor: LEE, Hangken, Daejeon 305-738 (KR); CHOI, Jeong Min, Daejeon 305-738 (KR); JANG, Songrim, Daejeon 305-738 (KR); CHO, Keun, Daejeon 305-738 (KR); LEE, Jaechol, Daejeon 305-738 (KR)
(74) Representative: Hoffmann Eitle
(86) International application number: PCT/KR2014/005219
(87) International publication number: WO 2014/200309

(56) References cited:
- WO-A1-2013/078580
- JP-A- H0 685 294
- KR-A- 20120 031 796
- KR-A- 20120 047 489
- KR-A- 20130 040 133
- KR-B1- 101 012 203
- US-A1- 2001 015 221
- US-A1- 2010 012 178
- JIN YOUNG KIM ET AL.: 'New Architecture for High-Efficiency Polymer Photovoltaic Cells Using Solution-Based Titanium Oxide as an Optical Spacer' ADVANCED MATERIALS vol. 18, no. 5, 01 March 2006, pages 572 - 576, XP055293418 DOI: 10.1002/ADMA.200501825
- None

## Description

### [Technical Field]

This application claims priority to and the benefit of Korean Patent Application No. 10-2013-0068543 filed in the Korean Intellectual Property Office on June 14, 2013.

The present specification relates to an organic solar cell and a method of manufacturing the same.

### [Background Art]

Currently, a mostly used energy source is petroleum, coal, and gas. This reaches 80% of the used entire energy source. However, recently, a depletion state of petroleum and coal energy has gradually become a large problem, and increased discharging of carbon dioxide and other greenhouse gases into the atmosphere has gradually caused a serious environmental problem. However, the use of renewable energy that is pollution-free green energy still only comes to about 2% of the entire energy source. Therefore, present problems for solving the depletion of the energy source serve as a momentum of further spurring research for developing new renewable energy. Among new renewable energies such as wind, water, and the sun, solar energy has received the greatest attention. A solar cell using solar energy pollutes less and has limitless resources and a semi-permanent life-span, and thus is expected as an energy source capable of solving future energy problems.

The solar cell is a device that can directly convert solar energy into electric energy by applying a photovoltaic effect. The solar cell may be divided into an inorganic solar cell and an organic solar cell according to a material constituting a thin film. A typical solar cell is manufactured by doping crystalline silicon (Si) that is an inorganic semiconductor to perform p-n conjunction. An electron and a hole generated by absorbing light are diffused to a p-n conjunction point, and are accelerated by an electric field thereof to move to an electrode. Electric power conversion efficiency of this process is defined by a ratio of electric power provided to an external circuit and solar power provided to the solar cell, and recently, has attained about 24% when measured under a standardized virtual solar radiation condition. However, since an inorganic solar cell in the related art already has limitations in view of economic feasibility and supply and demand on materials, an organic solar cell that is easily processed, is inexpensive, and includes various functionalities has come into the limelight as a long-term alternative energy source.

A group led by Professor Heeger at UCSB, US, has dominantly led technical development for an early organic solar cell. A unimolecular organic material or a polymer material used in the organic solar cell has a merit in that an easy, rapid, low-priced, and large-area process is feasible.

However, in research to the present time, the organic solar cell has a drawback in that energy conversion efficiency is still low. Therefore, at this point in time, it can be said that it is very important to improve efficiency in order to secure competitiveness with other solar cells.

### [Prior Art Documents]

Korean Patent Application Laid-Open No. 2013-0090304

WO2013/078580 discloses a polymer solar cell and a method for prearing the same; KR20120031796A relates to multilayer type organic solar cells.

### [Detailed Description of the Invention]

### [Technical Problem]

The present specification has been made in an effort to provide an organic solar cell and a method of manufacturing the same.

### [Technical Solution]

The present invention is defined by the enclosed claims and relates to the organic solar cell of claim 1 and the method of manufacturing an organic solar cell of claim 6.

The invention defines an organic solar cell according to claim 1 and a method of forming the solar cell according to claim 6. Preferred embodiments are defined in the dependent claims.

### [Advantageous Effects]

Since an organic solar cell according to an exemplary embodiment of the present specification has an excellent electron transmission ability, it is possible to increase a light short-circuit current density (J_{sc}) and increase efficiency.

Further, in the organic solar cell according to the exemplary embodiment of the present specification, it is possible to embody high efficiency by improving a fill factor (FF).

Further, in the organic solar cell according to the exemplary embodiment of the present specification, it is possible to improve an interface contact property of an electrode and an organic material layer, and it is possible to increase charge collection and prevent recombination of charges by reducing a charge injection barrier through adjustment of an energy barrier.

Further, in the organic solar cell according to the exemplary embodiment of the present specification, it is possible to reduce a heat treatment temperature during manufacturing to reduce a process cost.

Further, it is possible to manufacture the organic solar cell according to the exemplary embodiment of the present specification at a low heat treatment temperature, and thus has a merit in that a substrate made of a plastic material can be applied.

### [Brief Description of Drawings]

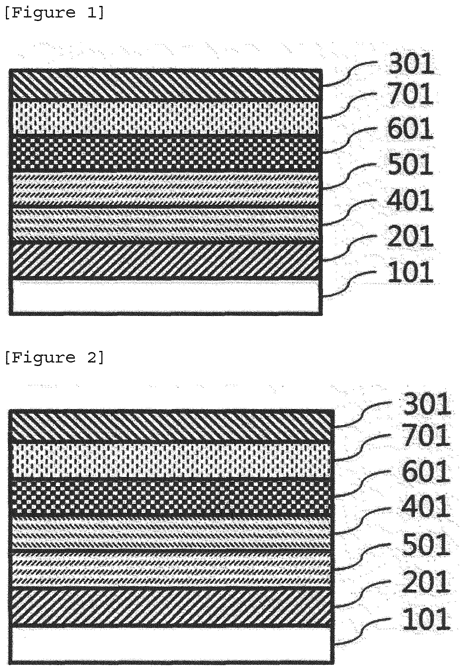

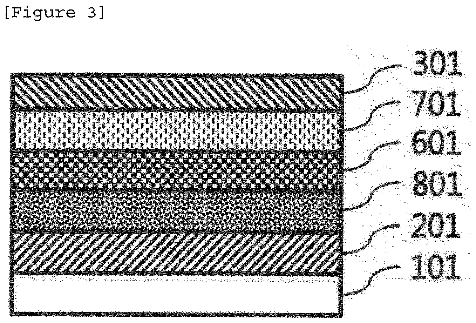

Figures 1 and 2 illustrate organic solar cells which are not claimed, figure 3 illustrates a solar cell useful for understanding the invention. The inventive solar cell is represented by figure 3 for the electron reform layer having a single layer structure including a metal oxide and MgF₂.

### [Best Mode]

In the present specification, it will be understood that when an element is referred to as being positioned "on" another element, the element can be directly on the other element or intervening elements may also be present between the two elements.

In the present specification, unless explicitly described to the contrary, the word "comprise" and variations such as "comprises" or "comprising", will be understood to imply the inclusion of stated other elements but not the exclusion of any other elements.

Hereinafter, the present specification will be described in more detail.

A solar cell useful for understanding the invention includes: a substrate; a first electrode provided on the substrate; a second electrode provided to face the first electrode; an organic material layer of one or more layers including a photoactive layer provided between the first electrode and the second electrode; and an electrode reformed layer provided between the first electrode and the photoactive layer, in which the electrode reformed layer has a two-layer structure formed of a layer including a metal oxide and a layer including a halogenated alkali-based metal, the layer including the metal oxide and the layer including the halogenated alkali-based metal are provided to come into contact with each other, and a cation of the halogenated alkali-based metal is diffused from an interface between the layer including the metal oxide and the layer including the halogenated alkali-based metal to a thickness of 15% or less of a total thickness of the layer including the metal oxide.

The cation of the halogenated alkali-based metal may be diffused from the interface between the layer including the metal oxide and the layer including the halogenated alkali-based metal to the thickness of 10% or less of the total thickness of the layer including the metal oxide.

The layer including the metal oxide may be provided on the first electrode, and the layer including the halogenated alkali-based metal may be provided on the layer including the metal oxide.

The layer including the halogenated alkali-based metal may be provided on the first electrode, and the layer including the metal oxide may be provided on the layer including the halogenated alkali-based metal.

FIGS. 1 and 2 illustrate a lamination structure of the organic solar cell not in accordance with the claimed invention. Specifically, FIGS. 1 and 2 illustrate a lamination structure where a first electrode 201 is provided on a substrate 101, a layer 401 including a metal oxide and a layer 501 including a halogenated alkali-based metal are provided as the electrode reformed layer of the two-layer structure on the first electrode 201, a photoactive layer 601 is provided on the electrode reformed layer, a buffer layer 701 of a second electrode is provided on the photoactive layer, and the second electrode is provided on the buffer layer 701 of the second electrode. However, the organic solar cell is not limited to the lamination structure of FIGS. 1 and 2, but an additional layer may be further provided.

The layer including the metal oxide may serve to reform a property of the first electrode. Specifically, in the case where the first electrode exhibits a p-type semiconductor property, the property of the first electrode may be changed by forming the layer including the metal oxide having an n-type semiconductor property.

In the case where there is no layer including the metal oxide, when the organic material layer comes into contact with the transparent electrode having the p-type semiconductor property, ohmic contact is not performed, and thus efficiency of the organic solar cell may be reduced. Therefore, the layer including the metal oxide may allow an electron flow between the transparent electrode and the organic material layer to be smooth. However, in the case where only the layer including the metal oxide is used as the electrode reformed layer, performance as the n-type layer is low. Further, there is a problem in that since an interface property with the organic material layer applied on the layer including the metal oxide is not good, charging efficiency of the organic solar cell is not good, and thus it is difficult to control the thickness and planarization of the thin film. Moreover, there is a problem in that since there is a need for a process where the layer including the metal oxide is subjected to heat treatment at high temperatures in order to generate a nano-structure, a use of a plastic substrate that is weak to heat and the like is limited. Therefore, the present inventors developed the organic solar cell capable of embodying high performance even though the heat treatment temperature of the layer including the metal oxide was reduced.

The organic solar cell may further include the layer including the halogenated alkali-based metal in addition to the layer including the metal oxide as the electrode reformed layer to implement excellent performance even though low heat treatment is performed. Specifically, the organic solar cell may reduce a charge injection barrier due to a dipole formed between the transparent electrode and the metal oxide or between the metal oxide and the photoactive layer. Further, in the organic solar cell a doping effect of the alkali-based metal caused by the layer including the halogenated alkali-based metal may occur to improve collection and transport properties of charges and increase a charge density.

The layer including the halogenated alkali-based metal may serve to reform the property of the transparent electrode and/or the layer including the metal oxide. There are merits in that the layer including the halogenated alkali-based metal may reduce an interface barrier with the organic material layer and the layer including the metal oxide may be formed even though low temperature heat treatment is performed.

Specifically, in the case where only the layer including the metal oxide is used as the electrode reformed layer, a high temperature heat treatment process at 200°C or more is required. However, in the organic solar cell the layer including the metal oxide may be formed by even a low temperature heat treatment process at 150°C or less.

The organic solar cell may improve a drawback of the layer including the metal oxide due to heat treatment at low temperatures, and thus there is a merit in that various kinds of substrates may be applied. That is, there is a merit in that a flexible substrate which is difficult to be applied to the high temperature, specifically a substrate made of a plastic, may be used to manufacture the organic solar cell.

The exemplary embodiment of the present specification provides an organic solar cell including: a substrate; a first electrode provided on the substrate; a second electrode provided to face the first electrode; an organic material layer of one or more layers including a photoactive layer provided between the first electrode and the second electrode; and an electrode reformed layer provided between the first electrode and the photoactive layer, in which the electrode reformed layer has a single layer structure including a metal oxide and MgF₂.

FIG. 3 illustrates a lamination structure of the organic solar cell useful for understanding the invention. Specifically, FIG. 3 illustrates a lamination structure where a first electrode 201 is provided on a substrate 101, an electrode reformed layer 801 of a single layer structure is provided on the first electrode 201, a photoactive layer 601 is provided on the electrode reformed layer 801, a buffer layer 701 of a second electrode is provided on the photoactive layer, and the second electrode is provided on the buffer layer 701 of the second electrode. However, the organic solar cell according to the exemplary embodiment of the present specification is not limited to the lamination structure of FIG. 3, but an additional layer may be further provided.

In the electrode reformed layer of the single layer structure, a ratio of a cation of the metal oxide and a cation of the MgF₂ may be 100 : 1 to 10 : 2.

The organic solar cell including the electrode reformed layer of the single layer structure may implement the same effect as the aforementioned organic solar cell including the electrode reformed layer of the two-layer structure. That is, the organic solar cell including the electrode reformed layer of the single layer structure may embody excellent performance by even the low temperature heat treatment process at 150°C or less. Specifically, a charge movement ability of the electrode reformed layer may be increased by the fluorinated magnesium and thus through even the low temperature heat treatment process, a highly conductive metal oxide structure may be formed in the electrode reformed layer. Particularly, there is a merit in that in the case of the electrode reformed layer of the single layer structure, the fluorinated magnesium-based layer may be easily embodied on a solution while not using a dry process such as deposition in order to constitute the fluorinated magnesium-based layer, and thus in the case of area enlargement, the organic solar cell is capable of being embodied at low costs.

According to the exemplary embodiment of the present specification, the electrode reformed layer may be provided to come into contact with the first electrode.

According to the exemplary embodiment of the present specification, the metal oxide may include one kind or two kinds or more selected from the group consisting of ZnO, TiOₓ, NiO, RuO, V₂O₅, WOₓ, Cs₂CO₃, MoO₃, ZrO₂, Ta₂O₃, and MgO.

According to the exemplary embodiment of the present specification, the metal oxide layer including MgF₂ may include one kind or two kinds or more selected from the group consisting of LiF, NaF, KF, RbF, CsF, FrF, BeF₂, CaF₂, SrF₂, BaF₂, and RaF₂.

According to the exemplary embodiment of the present specification, the layer including the metal oxide may be doped by alkali-based metal ions.

According to the exemplary embodiment of the present specification, the thickness of the electrode reformed layer of the single layer structure may be 5 nm or more and 200 nm or less. Specifically, according to the exemplary embodiment of the present specification, the thickness of the electrode reformed layer of the single layer structure may be 20 nm or more and 60 nm or less.

According to the exemplary embodiment of the present specification, the electrode reformed layer may be a transparent electrode reformed layer.

According to the exemplary embodiment of the present specification, the first electrode may be a transparent electrode.

According to the exemplary embodiment of the present specification, the second electrode may be a metal electrode.

According to the exemplary embodiment of the present specification, the first electrode may be the transparent electrode, and the second electrode may be the metal electrode.

According to the exemplary embodiment of the present specification, the first electrode and the second electrode may be the transparent electrode.

According to the exemplary embodiment of the present specification, the first electrode may be the metal electrode, and the second electrode may be the transparent electrode.

The term "transparent" of the present specification may mean that transmittance of a visible ray is 50% or more. Specifically, the term "transparent" may mean that transmittance of the visible ray is 75% or more and 100% or less.

According to the exemplary embodiment of the present specification, the transparent electrode may be a transparent conductive oxide layer. Specifically, as the transparent conductive oxide layer, in addition to glass and quartz plates, a matter where a material having conductivity is doped onto a flexible and transparent substrate such as a plastic including PET (polyethylene terephthalate), PEN (polyethylene naphthalate), PP (polypropylene), PI (polyimide), PC (polycarbonate), PS (polystyrene), POM (polyoxyethylene), an AS resin (acrylonitrile styrene copolymer), an ABS resin (acrylonitrile butadiene styrene copolymer), TAC (triacetyl cellulose), PAR (polyarylate), and the like may be used. More specifically, the transparent conductive oxide layer may be ITO (indium tin oxide), FTO (fluorine doped tin oxide), AZO (aluminum doped zinc oxide), IZO (indium zinc oxide), ZnO-Ga₂O₃, ZnO-Al₂O₃, ATO (antimony tin oxide), and the like, and even more specifically, the transparent conductive oxide layer may be ITO.

According to the exemplary embodiment of the present specification, the metal electrode may include one kind or two kinds or more selected from the group consisting of silver (Ag), aluminum (Al), platinum (Pt), tungsten (W), copper (Cu), molybdenum (Mo), gold (Au), nickel (Ni), and palladium (Pd). Even more specifically, the metal electrode may be silver (Ag).

According to the exemplary embodiment of the present specification, the substrate may include one kind or more selected from the group consisting of a glass, a polymer material, and a metal. Specifically, according to the exemplary embodiment of the present specification, the substrate may be a transparent substrate. Specifically, the transparent substrate may be a soda ash glass or transparent plastic, but is not limited thereto.

According to the exemplary embodiment of the present specification, the substrate may be a flexible substrate.

According to the exemplary embodiment of the present specification, the substrate may be a flexible substrate including a polymer material. Specifically, the substrate may be a substrate made of a plastic.

According to the exemplary embodiment of the present specification, the polymer material may include polyimide (PI), polycarbonate (PC), polyethersulfone (PES), polyetheretherketone (PEEK), polybutylene terephthalate (PBT), polyethylene terephthalate (PET), polyvinyl chloride (PVC), polyethylene (PE), an ethylene copolymer, polypropylene (PP), a propylene copolymer, poly(4-methyl-1-pentene) (TPX), polyarylate (PAR), polyacetal (POM), polyphenylene oxide (PPO), polysulfone (PSF), polyphenylene sulfide (PPS), polyvinylidene chloride (PVDC), polyvinyl acetate (PVAC), polyvinyl alcohol (PVAL), polyvinyl acetal, polystyrene (PS), an AS resin, an ABS resin, polymethyl methacrylate (PMMA), a fluorine resin, a phenol resin (PF), a melamine resin (MF), a urea resin (UF), unsaturated polyester (UP), an epoxy resin (EP), a diallyl phthalate resin (DAP), polyurethane (PUR), polyamide (PA), a silicon resin (SI), or a mixture and a compound thereof.

According to the exemplary embodiment of the present specification, the first electrode may be an anode, and the second electrode may be a cathode. Further, the first electrode may be the cathode, and the second electrode may be the anode.

According to the exemplary embodiment of the present specification, the organic solar cell may be an inverted structure. Specifically, the inverted structure means that the first electrode provided on the substrate is the cathode.

According to the exemplary embodiment of the present specification, the organic solar cell may be a normal structure. Specifically, the normal structure means that the first electrode provided on the substrate is the anode.

According to the exemplary embodiment of the present specification, the organic solar cell may further include a buffer layer of the second electrode provided between the photoactive layer and the second electrode. Specifically, according to the exemplary embodiment of the present specification, the buffer layer of the second electrode may be positioned between the metal electrode and the photoactive layer, and the buffer layer may control interfacial energy between the metal electrode and the photoactive layer to induce a smooth charge flow.

According to the exemplary embodiment of the present specification, the buffer layer of the second electrode may include a conductive polymer and/or a metal oxide. Specifically, as the conductive polymer, a conjugated polymer material, a dielectric polymer, a graphene carbon nanotube, a complex thereof, and the like are feasible. Specifically, the conjugated polymer material may be PEN (poly[(9,9-bis(30-(N,N-dimethylamino)propyl)-2,7-fluorene)-alt-2,7-(9,9-dioctylfluorene)]), FPQ-Br (poly[9,9'-bis[6''-(N,N,N-trimethylammonium)hexyl]fluorene-co-alt-phenylene] dibromide), and the like. Further, the dielectric polymer may be PEI (polyethylenimine), PEIE (polyethylenimine ethoxylated), and the like. Further, the conductive polymer may include one kind or two kinds or more selected from the group consisting of a phthalocyanine derivative, a naphthalocyanine derivative, an aromatic amine compound, polyethylenedioxythiophene (PEDOT : PSS), and polyaniline.

According to the exemplary embodiment of the present specification, the metal oxide included in the buffer layer of the second electrode may include V₂O₅ and/or MoO₃.

According to the exemplary embodiment of the present specification, the photoactive layer may be a bulk heterojunction structure or a double layer junction structure. The bulk heterojunction structure may be a bulk heterojunction (BHJ) junction type, and the double layer junction structure may be a bi-layer junction type. The bi-layer p-n junction-type photoactive unit includes a photoactive layer formed of two layers of a p-type semiconductor thin film and an n-type semiconductor thin film. The BHJ (bulk heterojunction) junction-type photoactive unit includes a photoactive layer where an n-type semiconductor and a p-type semiconductor are blended.

In the photoactive layer of the present specification, due to photo-excitation, the p-type semiconductor forms an exciton where a pair is formed by an electron and a hole, and the exciton is divided into the electron and the hole at a p-n junction portion. The divided electron and hole may move into the n-type semiconductor thin film and the p-type semiconductor thin film, respectively, and may be collected in the first electrode and the second electrode, respectively, to be used as electric energy in the outside.

In the exemplary embodiment of the present specification, the photoactive layer includes an electron donor material and an electron acceptor material as a photoactive material. In the present specification, the photoactive material may mean the electron donor material and the electron acceptor material.

In the photoactive layer, due to photo-excitation, the electron donor material forms the exciton where a pair is formed by the electron and the hole, and the exciton is divided into the electron and the hole at an interface of the electron donor/electron acceptor. The divided electron and hole may move into the electron donor material and the electron acceptor material, respectively, and may be collected in the first electrode and the second electrode, respectively, to be used as electric energy in the outside.

According to the exemplary embodiment of the present specification, a mass ratio of the electron donor material and the electron acceptor material may be 1 : 10 to 10 : 1. Specifically, the mass ratio of the electron acceptor material and the electron donor material of the present specification may be 1 : 0.5 to 1 : 5.

In the photoactive layer of the present specification, an electron donating material and an electron accepting material may form BHJ (bulk heterojunction). The photoactive layer of the present specification may be annealed at 30 to 300°C for 1 second to 24 hours in order to maximize a property after the electron donating material and the electron accepting material are mixed.

According to the exemplary embodiment of the present specification, the photoactive layer may include at least one kind of electron donor material and at least one kind of electron acceptor material.

According to the exemplary embodiment of the present specification, the photoactive layer may include at least two kinds of electron donor materials and at least one kind of electron acceptor material.

According to the exemplary embodiment of the present specification, the photoactive layer may include at least one kind of electron donor material and at least two kinds of electron acceptor materials.

According to the exemplary embodiment of the present specification, the electron donor material may include at least one kind of electron donor; or a polymer of at least one kind of electron acceptor and at least one kind of electron donor. The electron donating material may include at least one kind of electron donor. Further, the electron donor material may include a polymer of at least one kind of electron acceptor and at least one kind of electron donor.

Specifically, according to the exemplary embodiment of the present specification, the electron donor material may be a copolymer including at least one of electron acceptors represented by the following Chemical Formulas.

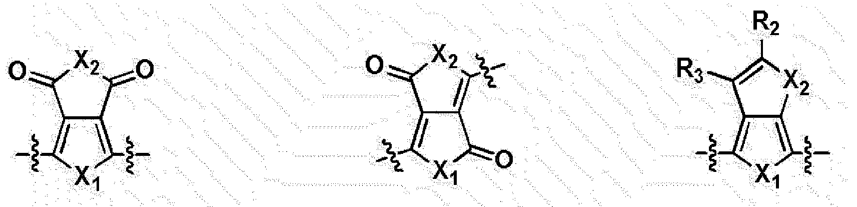

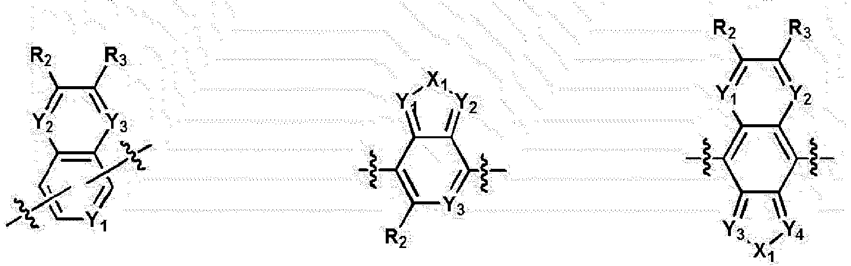

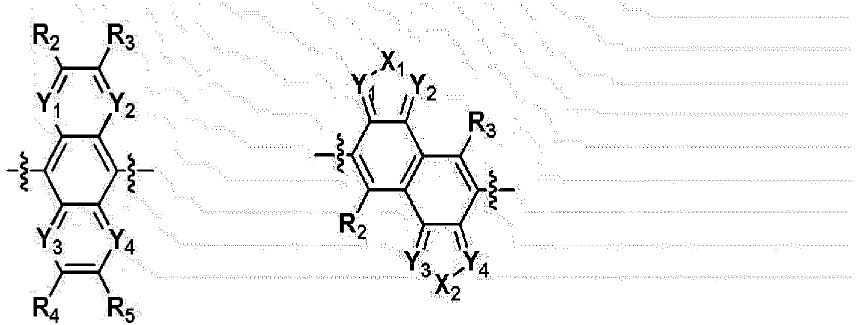

In the electron donor material, R₂ to R₅ are the same as or different from each other, and are each independently selected from the group consisting of hydrogen; deuterium; a halogen group; a nitrile group; a nitro group; an imide group; an amide group; a hydroxy group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted alkylamine group; a substituted or unsubstituted aralkylamine group; a substituted or unsubstituted arylamine group; a substituted or unsubstituted heteroarylamine group; a substituted or unsubstituted aryl group; a substituted or unsubstituted fluorenyl group; a substituted or unsubstituted carbazole group; and a substituted or unsubstituted heterocyclic group including one or more of N, O, and S atoms, or two adjacent substituent groups may form a condensation cycle.

X₁ and X₂ are the same as or different from each other, and are each independently selected from the group consisting of CRR', NR, O, SiRR', PR, S, GeRR', Se, and Te, Y₁ to Y₄ are the same as or different from each other, and are each independently selected from the group consisting of CR, N, SiR, P, and GeR.

R and R' are the same as or different from each other, and are each independently selected from the group consisting of hydrogen; deuterium; a halogen group; a nitrile group; a nitro group; an imide group; an amide group; a hydroxy group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted alkylamine group; a substituted or unsubstituted aralkylamine group; a substituted or unsubstituted arylamine group; a substituted or unsubstituted heteroarylamine group; a substituted or unsubstituted aryl group; a substituted or unsubstituted fluorenyl group; a substituted or unsubstituted carbazole group; and a substituted or unsubstituted heterocyclic group including one or more of N, O, and S atoms, or two adjacent substituent groups may form a condensation cycle.

Further, according to the exemplary embodiment of the present specification, the electron donor material may be a copolymer including at least one of electron donors represented by the following Chemical Formulas.

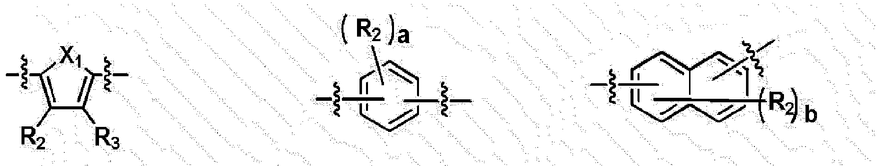

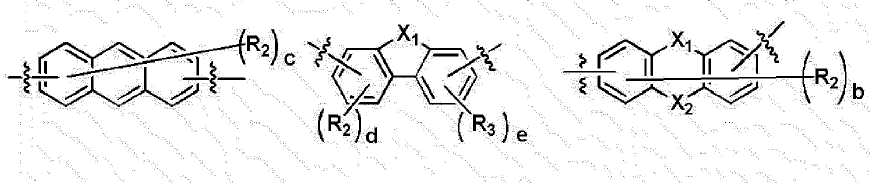

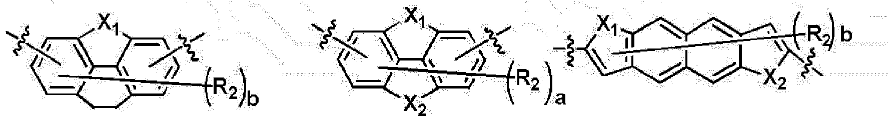

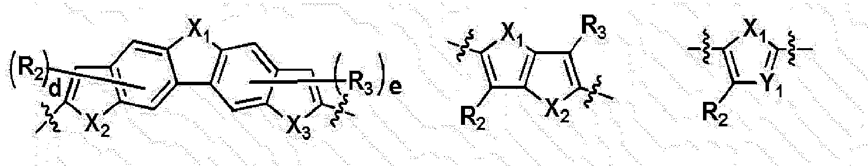

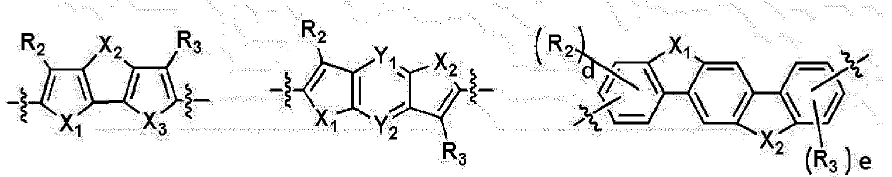

In the electron donor, R₂ and R₃ are the same as or different from each other, and are each independently selected from the group consisting of hydrogen; deuterium; a halogen group; a nitrile group; a nitro group; an imide group; an amide group; a hydroxy group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted alkylamine group; a substituted or unsubstituted aralkylamine group; a substituted or unsubstituted arylamine group; a substituted or unsubstituted heteroarylamine group; a substituted or unsubstituted aryl group; a substituted or unsubstituted fluorenyl group; a substituted or unsubstituted carbazole group; and a substituted or unsubstituted heterocyclic group including one or more of N, O, and S atoms, or two adjacent substituent groups may form a condensation cycle.

X₁ to X₃ are the same as or different from each other, and are each independently selected from the group consisting of CRR', NR, O, SiRR', PR, S, GeRR', Se, and Te, Y₁ and Y₂ are the same as or different from each other, and are each independently selected from the group consisting of CR, N, SiR, P, and GeR.

R and R' are the same as or different from each other, and are each independently selected from the group consisting of hydrogen; deuterium; a halogen group; a nitrile group; a nitro group; an imide group; an amide group; a hydroxy group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted alkylamine group; a substituted or unsubstituted aralkylamine group; a substituted or unsubstituted arylamine group; a substituted or unsubstituted heteroarylamine group; a substituted or unsubstituted aryl group; a substituted or unsubstituted fluorenyl group; a substituted or unsubstituted carbazole group; and a substituted or unsubstituted heterocyclic group including one or more of N, O, and S atoms, or two adjacent substituent groups may form a condensation cycle.

a may be an integer of 1 to 4, b may be an integer of 1 to 6, c may be an integer of 1 to 8, d may be an integer of 1 to 3, and e may be an integer of 1 to 3.

According to the exemplary embodiment of the present specification, the photoactive layer may further include an additive.

According to the exemplary embodiment of the present specification, the additive may be a material for adjusting movement of charges and a density of the charges, and specifically, may be a Lewis acid material, F4-TCNQ, a dihydrobenzoimidazole-based material, a metallocene dimer material, and the like.

Further, according to the exemplary embodiment of the present specification, the additive may be a material for adjusting miscibility and/or morphology of the photoactive layer, and specifically, may be 1,8-diiodooctane, 1,8-octanedithiol, triethyleneglycol, 1,8-dibromooctane, 1,4-diiodobutane, 1,6-diiodohexane, hexadecane, diethyleneglycoldibutylether, 1-chloronaphthalene, nitrobenzene, 4-bromoanisole, N-methyl-2-pyrrolidone, 3-methylthiophene, 3-hexylthiophene, polydimethylsiloxane, 1-methylnaphthalene, diphenylether; a polymer such as polystyrene (PS) and polymethyl methacrylate (PMMA), and the like.

Specifically, the electron donor material may be various polymer materials and a unimolecular material such as thiophenes, fluorenes, and carbazoles starting from MEH-PPV (poly[2-methoxy-5-2'-ethyl-hexyloxy)-1,4-phenylene vinylene]).

Specifically, the unimolecular material may include one kind or more materials selected from the group consisting of copper (II) phthalocyanine, zinc phthalocyanine, tris[4-5-dicyanomethylidenemethyl-2-thienyl)phenyl]amine), 2,4-bis[4-(N,N-dibenzylamino)-2,6-dihydroxyphenyl]squaraine, benz[b]anthracene, and pentacene.

Specifically, the polymer material may include one kind or more materials selected from the group consisting of poly 3-hexyl thiophene (P3HT), PCDTBT (poly[N-9'-heptadecanyl-2,7-carbazole-alt-5,5- 4'-7'-di-2-thienyl-2',1',3'-benzothiadiazole)]), PCPDTBT (poly[2,6- 4,4-bis-2-ethylhexyl)-4H-cyclopenta[2,1-b;3,4-b']dithiophene)-alt-4,7- 2,1,3-benzothiadiazole)]), PFO-DBT (poly[2,7-(9,9-dioctyl-fluorene)-alt-5,5- 4,7-di 2-thienyl-2,1,3-benzothiadiazole)]), PTB7 (poly[[4,8-bis[ 2-ethylhexyl)oxy]benzo[1,2-b : 4,5-b']dithiophene-2,6-diyl][3-fluoro-2-[ 2-ethylhexyl)carbonyl]thieno[3,4-b]thiophenediyl]]), and PSiF-DBT (poly[2,7-(9,9-dioctyl-dibenzosilole)-alt-4,7-bis(thiophen-2-yl)benzo-2,1,3-thiadiazole]).

According to the exemplary embodiment of the present specification, the electron acceptor material may be a fullerene derivative or a non-fullerene derivative.

According to the exemplary embodiment of the present specification, the fullerene derivative is a C60 to C90 fullerene derivative. Specifically, the fullerene derivative may be a C60 fullerene derivative or a C70 fullerene derivative.

According to the exemplary embodiment of the present specification, the C60 fullerene derivative or the C70 fullerene derivative is each independently selected from the group consisting of hydrogen; deuterium; a halogen group; a nitrile group; a nitro group; an imide group; an amide group; a hydroxy group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted alkylamine group; a substituted or unsubstituted aralkylamine group; a substituted or unsubstituted arylamine group; a substituted or unsubstituted heteroarylamine group; a substituted or unsubstituted aryl group; and a substituted or unsubstituted heterocyclic group including one or more of N, O, and S atoms, or two adjacent substituent groups may be further substituted by a substituent group forming a condensation cycle.

According to the exemplary embodiment of the present specification, the fullerene derivative may be selected from the group consisting of a C76 fullerene derivative, a C78 fullerene derivative, a C84 fullerene derivative, and a C90 fullerene derivative.

According to the exemplary embodiment of the present specification, the C76 fullerene derivative, the C78 fullerene derivative, the C84 fullerene derivative, and the C90 fullerene derivative are each independently selected from the group consisting of hydrogen; deuterium; a halogen group; a nitrile group; a nitro group; an imide group; an amide group; a hydroxy group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted silyl group; a substituted or unsubstituted boron group; a substituted or unsubstituted alkylamine group; a substituted or unsubstituted aralkylamine group; a substituted or unsubstituted arylamine group; a substituted or unsubstituted heteroarylamine group; a substituted or unsubstituted aryl group; and a substituted or unsubstituted heterocyclic group including one or more of N, O, and S atoms, or two adjacent substituent groups may be further substituted by a substituent group forming a condensation cycle.

The fullerene derivative has excellent separation ability of electron-hole pairs (exciton) and charge mobility as compared to the non-fullerene derivative, and thus, is advantageous in terms of efficiency characteristic.

According to the exemplary embodiment of the present specification, the photoactive layer may include poly 3-hexyl thiophene [P3HT] as the electron donor material and [6, 6]-phenyl-C₆₁-butyric acid methylester (PC₆₁BM) and/or [6, 6]-phenyl-C₇₁-butyric acid methylester (PC₇₁BM) as the electron acceptor material.

In the exemplary embodiment of the present specification, a mass ratio of the electron donor material and the electron acceptor material may be 1 : 0.4 to 1 : 2 and specifically 1 : 0.7. However, the photoactive layer is not limited to the aforementioned materials.

After the aforementioned photoactive materials are dissolved in an organic solvent, a solution is applied by a method such as spin coating to introduce the photoactive layer in a thickness in the range of 50 nm to 280 nm. In this case, to the photoactive layer, a method such as dip coating, screen printing, spray coating, doctor blade, and brush painting may be applied.

Further, since the electron acceptor includes PC₆₁BM, other fullerene derivatives such as C70, C76, C78, C80, C82, and C84 may be used, and the coated thin film may be subjected to heat treatment at 80°C to 160°C to increase crystallinity of the conductive polymer.

The hole transport layer and/or electron transport layer materials of the present specification may be a material efficiently transporting an electron and a hole to the photoactive layer to increase a possibility of movement of generated charges to the electrode, but are not particularly limited thereto.

According to the exemplary embodiment of the present specification, the hole transport layer may include one or more kinds selected from the group consisting of PEDOT:PSS; molybdenum oxide (MoOₓ); vanadium oxide (V₂O₅); nickel oxide (NiO); and tungsten oxide (WOₓ).

According to the exemplary embodiment of the present specification, the hole transport layer may be an anode buffer layer.

On an upper portion of the pre-treated photoactive layer, the hole transport layer may be introduced through a method such as spin coating, dip coating, inkjet printing, gravure printing, spray coating, doctor blade, bar coating, gravure coating, brush painting, and heat deposition. According to the exemplary embodiment of the present specification, the hole transport layer may be formed in a thickness of 5 nm to 10 nm through a heat deposition system of MoO₃.

According to the exemplary embodiment of the present specification, the organic solar cell may have a wound structure. Specifically, the organic solar cell may be manufactured in a flexible film form, and may be manufactured into a solar cell of a wound structure which is hollow therein by rolling in a cylindrical form. In the case where the organic solar cell has a wound structure, the organic solar cell may be installed in a mode where the organic solar cell stands on the ground. In this case, at a position at which the organic solar cell is installed, while the sun moves from the east to the west, a portion where an incident angle of light becomes maximum may be secured. Therefore, there is a merit in that while the sun is in the sky, light may be absorbed as much as possible to increase efficiency.

According to the exemplary embodiment of the present specification, the organic solar cell may further include an organic material layer of one or more layers selected from the group consisting of a hole injection layer; a hole transport layer; an interlayer; a hole blocking layer; a charge generating layer; an electron blocking layer; and an electron transport layer between the first electrode and the second electrode.

According to the exemplary embodiment of the present specification, the hole transport layer and/or electron transport layer materials may be a material efficiently transporting an electron and a hole to the photoactive layer to increase a possibility of movement of generated charges to the electrode, but are not particularly limited thereto.

The interlayer refers to a layer positioned between the hole injection layer and the hole transport layer.

The charge generating layer refers to a layer generating a hole and an electron if a voltage is applied.

According to the exemplary embodiment of the present specification, the electron transport layer may include one or two or more selected from the group consisting of a conductive oxide and a metal.

According to the exemplary embodiment of the present specification, the conductive oxide of the electron transport layer may be an electron-extracting metal oxides, and specifically, may include one or more kinds selected from the group consisting of titanium oxide (TiOₓ); zinc oxide (ZnO); and cesium carbonate (Cs₂CO₃).

The electron transport layer may be formed by application on one surface of the first electrode or coating in a film form by using a sputtering, E-beam, heat deposition, spin coating, screen printing, inkjet printing, doctor blade, or gravure printing method.

According to the exemplary embodiment of the present specification, the electron transport layer may be a cathode buffer layer.

Hereinafter, a method of manufacturing an organic solar cell according to the exemplary embodiment of the present specification will be described.

A method, which is not claimed, of manufacturing an organic solar cell, the method includes: preparing a substrate; forming a first electrode on the substrate; forming an electrode reformed layer on the first electrode; forming an organic material layer of one or more layers including a photoactive layer on the electrode reformed layer; and forming a second electrode on the organic material layer, in which the electrode reformed layer has a two-layer structure formed of a layer including a metal oxide and a layer including a halogenated alkali-based metal, the layer including the metal oxide and the layer including the halogenated alkali-based metal are provided to come into contact with each other, and a cation of the halogenated alkali-based metal is diffused from an interface between the layer including the metal oxide and the layer including the halogenated alkali-based metal to a thickness of 15% or less of a total thickness of the layer including the metal oxide.

The exemplary embodiment of the present specification provides a method of manufacturing an organic solar cell, the method including: preparing a substrate; forming a first electrode on the substrate; forming an electrode reformed layer on the first electrode; forming an organic material layer of one or more layers including a photoactive layer on the electrode reformed layer; and forming a second electrode on the organic material layer, in which the electrode reformed layer has a single layer structure including a metal oxide and MgF₂.

According to the exemplary embodiment of the present specification, the metal oxide layer may be formed by omitting a heat treatment process or may be formed by using the heat treatment process at 50°C or more and 250°C or less.

According to the exemplary embodiment of the present specification, the electrode reformed layer of the single layer structure may be formed by omitting the heat treatment process or may be formed by using the heat treatment process at 50°C or more and 250°C or less.

According to the exemplary embodiment of the present specification, the electrode reformed layer may be formed by a solution process using MgF₂-based particles and metal oxide particles.

In the electrode reformed layer of the two-layer structure, which is not claimed, the layer including the metal oxide and the layer including the halogenated alkali-based metal may be each formed by the solution process. Alternatively, in the electrode reformed layer of the two-layer structure, which is not claimed, the layer including the metal oxide may be formed by the solution process, and the layer including the halogenated alkali-based metal may be formed by using a deposition process.

According to the exemplary embodiment of the present specification, the electrode reformed layer of the single layer structure may be formed by using a sol-gel coating solution where the halogenated alkali-based metal particles and the metal oxide particles are dispersed.

According to the exemplary embodiment of the present specification, the electrode reformed layer of the single layer structure may be formed by dispersing the halogenated alkali-based metal particles and the metal oxide particles in the solution.

Hereinafter, the present specification will be specifically described in detail through Examples. However, the Examples according to the present specification may be modified in various other forms. The Examples of the present specification are provided so that a person with ordinary skill in the art may fully understand the present specification. Examples 1 to 7 are reference examples.

### [Example 1]

The ITO glass was washed in acetone and ethanol for 30 minutes each by using sonication, and was subjected to surface treatment for 15 minutes by using UVO (uv/ozone). After the ZnO solution was applied on the ITO glass, heat treatment was performed at 200°C for 10 minutes. After LiF was deposited on the ZnO layer under the vacuum at the degree of vacuum of 1 × 10⁻⁷ torr in the thickness of 1 Å, the solution of P₃HT and PCBM mixed at the ratio of 1 : 0.7 was applied to form the photoactive layer of about 220 nm, followed by heat treatment at 110°C for 10 minutes. The MoO₃/Ag electrode was deposited on the photoactive layer at 1 × 10⁻⁷ torr to manufacture the organic solar cell.

### [Example 2]

The organic solar cell was manufactured by the same method as Example 1, except that LiF was deposited in the thickness of 3 Å.

### [Example 3]

The organic solar cell was manufactured by the same method as Example 1, except that LiF was deposited in the thickness of 5 Å.

### [Comparative Example 1]

The organic solar cell was manufactured by the same method as Example 1 while the LiF layer was not formed.

Physical properties of the organic solar cell according to Examples 1 to 3 and Comparative Example 1 are described in the following Table 1.

**[Table 1]**

| | LiF thickness (Å)) | Voc (V) | Jsc (mA/cm²) | FF | PCE (%) |
|---|---|---|---|---|---|
| Comparative Example 1 | 0 | 0.628 | 8.48 | 0.5 75 | 3.06 |
| Example 1 | 1 | 0.622 | 7.92 | 0.5 2 | 2.56 |
| Example 2 | 3 | 0.634 | 8.86 | 0.6 | 3.37 |
| Example 3 | 5 | 0.636 | 8.57 | 0.5 98 | 3.26 |

In the present specification, V_{oc} means an open-circuit voltage, J_{sc} means a short-circuit current, FF means a fill factor, and PCE means energy conversion efficiency. The open-circuit voltage and the short-circuit current are respectively intercepts of X and Y axes in fourth quadrants of a voltage-current density curve, and as these two values are increased, efficiency of the solar cell is preferably increased. Further, the fill factor is a value obtained by dividing an area of a rectangle that may be drawn in the curve by the product of the short-circuit current and the open-circuit voltage. If these three values are divided by the intensity of radiated light, energy conversion efficiency may be obtained, and the higher the value is, the better the efficiency is.

### [Example 4]

The ITO glass was washed in acetone and ethanol for 30 minutes each by using sonication, and was subjected to surface treatment for 15 minutes by using UVO (uv/ozone). The ZnO solution was applied on the ITO glass, and was then dried without heat treatment. After LiF was deposited on the ZnO layer under the vacuum at the degree of vacuum of 1 × 10⁻⁷ torr in the thickness of 3 Å, the solution of P₃HT and PCBM mixed at the ratio of 1 : 0.7 was applied to form the photoactive layer of about 220 nm, followed by heat treatment at 110°C for 10 minutes. The MoO₃/Ag electrode was deposited on the photoactive layer at 1 × 10⁻⁷ torr to manufacture the organic solar cell.

### [Example 5]

The organic solar cell was manufactured by the same method as Example 4, except that ZnO was subjected to heat treatment at 100°C for 10 minutes.

### [Example 6]

The organic solar cell was manufactured by the same method as Example 4, except that ZnO was subjected to heat treatment at 150°C for 10 minutes.

### [Example 7]

The organic solar cell was manufactured by the same method as Example 4, except that ZnO was subjected to heat treatment at 200°C for 10 minutes.

### [Comparative Example 2]

The organic solar cell was manufactured by the same method as Example 4 while the LiF layer was not formed.

### [Comparative Example 3]

The organic solar cell was manufactured by the same method as Example 5 while the LiF layer was not formed.

### [Comparative Example 4]

The organic solar cell was manufactured by the same method as Example 6 while the LiF layer was not formed.

### [Comparative Example 5]

The organic solar cell was manufactured by the same method as Example 7 while the LiF layer was not formed.

Physical properties of the organic solar cell according to Examples 4 to 7 and Comparative Examples 2 to 5 are described in the following Table 2.

**[Table 2]**

| | Heat treatment temperature (°C) | Voc (V) | Jsc (mA/cm² ) | FF | PCE (%) |
|---|---|---|---|---|---|
| Example 4 | No heat treatment | 0.51 8 | 0.015 | 0.56 4 | 4.46×1 0-3 |
| Example 5 | 100 | 0.59 8 | 0.063 | 0.42 3 | 0.016 |
| Example 6 | 150 | 0.61 2 | 10.98 | 0.60 7 | 4.08 |
| Example 7 | 200 | 0.61 | 10.91 | 0.59 8 | 3.98 |
| Comparative Example 2 | No heat treatment | 0.52 | 0.013 | 0.29 8 | 2.08×1 0-3 |
| Comparative Example 3 | 100 | 0.57 4 | 0.04 | 0.34 9 | 7.94×1 0-3 |
| Comparative Example 4 | 150 | 0.59 2 | 10.81 | 0.49 6 | 3.18 |
| Comparative Example 5 | 200 | 0.60 8 | 10.96 | 0.55 5 | 3.7 |

### [Example 8]

The ITO glass was washed in acetone and ethanol for 30 minutes each by using sonication, and was subjected to surface treatment for 15 minutes by using UVO (UV/ozone). After MgF₂ was deposited on the ITO glass under the vacuum at the degree of vacuum of 1 × 10⁻⁷ torr in the thickness of 1 Å, the ZnO solution was applied to perform heat treatment at 200°C for 10 minutes. On the ZnO layer, the solution where PBDTTPD (poly(benzo[1,2-b : 4,5-b']dithiophenealt-thieno[3,4-c]pyrrole-4,6-dione) and PC₆₁BM were applied at the ratio of 1 : 1.5 was applied in the thickness of 100 nm, and heat treatment was then performed at 80°C for 5 minutes to form the photoactive layer. The MoO₃/Ag electrode was deposited on the photoactive layer at 1 × 10⁻⁷ torr to manufacture the organic solar cell.

### [Example 9]

The organic solar cell was manufactured by the same method as Example 8, except that the MgF₂ layer was formed in the thickness of 3 Å.

### [Example 10]

The organic solar cell was manufactured by the same method as Example 8, except that the MgF₂ layer was formed in the thickness of 5 Å.

### [Comparative Example 6]

The organic solar cell was manufactured by the same method as Example 8 while the MgF₂ layer was not formed.

Physical properties of the organic solar cell according to Examples 8 to 10 and Comparative Example 6 are described in the following Table 3.

**[Table 3]**

| | MgF₂ thickness (Å) | Voc (V) | Jsc (mA/cm²) | FF | PCE (% ) |
|---|---|---|---|---|---|
| Comparative Example 6 | 0 | 0.962 | 12.365 | 0.5 45 | 6.487 |
| Example 8 | 1 | 0.964 | 13.029 | 0.6 15 | 7.73 |
| Example 9 | 3 | 0.975 | 12.628 | 0.5 88 | 7.24 |
| Example 10 | 5 | 0.967 | 12.22 | 0.6 08 | 7.19 |

### <Explanation of Reference Numerals and Symbols>

101: Substrate
201: First electrode
301: Second electrode
401: Layer including metal oxide
501: Layer including halogenated alkali-based metal
601: Photoactive layer
701: Buffer layer of second electrode
801: Electrode reformed layer of single layer structure

## Claims

1. An organic solar cell comprising:
a substrate (101);
a first electrode (201) provided on the substrate;
a second electrode (301) provided to face the first electrode;
an organic material layer of one or more layers including a photoactive layer (601) provided between the first electrode and the second electrode; and
an electrode reformed layer (801) provided between the first electrode and the photoactive layer,
wherein the electrode reformed layer has a single layer structure **characterized by** the electrode reform layer including a metal oxide and MgF₂.

2. The organic solar cell of claim 1, wherein in the electrode reformed layer (801), a ratio of a cation of the metal oxide and a cation of MgF₂ is 100 : 1 to 10 : 2.

3. The organic solar cell of claim 1, wherein the electrode reformed layer (801) is provided to come into contact with the first electrode (201).

4. The organic solar cell of claim 1, wherein the first electrode (201) is a transparent electrode.

5. The organic solar cell of claim 1, wherein a thickness of the electrode reformed layer (801) is 5 nm or more and 200 nm or less.

6. A method of manufacturing an organic solar cell, the method comprising:
preparing a substrate (101);
forming a first electrode (201) on the substrate;
forming an electrode reformed layer (801) on the first electrode;
forming an organic material layer of one or more layers including a photoactive layer (601) on the electrode reformed layer; and
forming a second electrode(301) on the organic material layer,
wherein the electrode reformed layer has a single layer structure **characterized by** the electrode reform layer including a metal oxide and MgF₂.

7. The method of claim 6, wherein the metal oxide layer is formed by omitting a heat treatment process or is formed by using the heat treatment process at 50°C or more and 250°C or less.

## Patentansprüche

1. Organische Solarzelle, umfassend:
ein Substrat (101);
eine auf dem Substrat angeordnete erste Elektrode (201);
eine zweite Elektrode (301), welche so angeordnet ist, dass sie der ersten Elektrode gegenüberliegt;
eine organische Materialschicht aus einer oder mehreren Schichten enthaltend eine photoaktive Schicht (601), welche zwischen der ersten Elektrode und der zweiten Elektrode angeordnet ist; und
eine zwischen der ersten Elektrode und der photoaktiven Schicht angeordnete reformierte Elektrodenschicht (801),
wobei die reformierte Elektrodenschicht eine Einzelschichtstruktur aufweist, **dadurch gekennzeichnet, dass** die reformierte Elektrodenschicht ein Metalloxid und MgF₂ enthält.

2. Organische Solarzelle gemäß Anspruch 1, wobei in der reformierten Elektrodenschicht (801) ein Verhältnis eines Kations des Metalloxids und eines Kations von MgF₂ 100 : 1 bis 10 : 2 beträgt.

3. Organische Solarzelle gemäß Anspruch 1, wobei die reformierte Elektrodenschicht (801) so angeordnet ist, dass sie mit der ersten Elektrode (201) in Kontakt kommt.

4. Organische Solarzelle gemäß Anspruch 1, wobei die erste Elektrode (201) eine transparente Elektrode ist.

5. Organische Solarzelle gemäß Anspruch 1, wobei eine Dicke der reformierten Elektrodenschicht (801) 5 nm oder mehr und 200 nm oder weniger beträgt.

6. Verfahren zur Herstellung einer organischen Solarzelle, wobei das Verfahren umfasst:
Herstellen eines Substrats (101);
Ausbilden einer ersten Elektrode (201) auf dem Substrat;
Ausbilden einer reformierten Elektrodenschicht (801) auf der ersten Elektrode;
Ausbilden einer organischen Materialschicht aus einer oder mehreren Schichten einschließlich einer photoaktiven Schicht (601) auf der reformierten Elektrodenschicht; und
Bilden einer zweiten Elektrode (301) auf der organischen Materialschicht,
wobei die reformierte Elektrodenschicht eine Einzelschichtstruktur aufweist, **dadurch gekennzeichnet, dass** die reformierte Elektrodenschicht ein Metalloxid und MgF₂ enthält.

7. Verfahren gemäß Anspruch 6, wobei die Metalloxidschicht durch Weglassen eines Wärmebehandlungsprozesses gebildet wird oder durch Anwendung des Wärmebehandlungsprozesses bei 50°C oder mehr und 250°C oder weniger gebildet wird.

## Revendications

1. Cellule solaire organique comprenant :
un substrat (101) ;
une première électrode (201) prévue sur le substrat ;
une seconde électrode (301) prévue pour faire face à la première électrode ;
une couche de matière organique d'une ou plusieurs couches incluant une couche photoactive (601) prévue entre la première électrode et la seconde électrode ; et
une couche reformée d'électrode (801) prévue entre la première électrode et la couche photoactive,
dans laquelle la couche reformée d'électrode présente une structure à une seule couche **caractérisée en ce que** la couche de reformage d'électrode inclut un oxyde métallique et du MgF₂.

2. Cellule solaire organique selon la revendication 1, dans laquelle dans la couche reformée d'électrode (801), un rapport d'un cation de l'oxyde métallique et d'un cation de MgF₂ est de 100:1 à 10:2.

3. Cellule solaire organique selon la revendication 1, dans laquelle la couche reformée d'électrode (801) est prévue pour venir en contact avec la première électrode (201).

4. Cellule solaire organique selon la revendication 1, dans laquelle la première électrode (201) est une électrode transparente.

5. Cellule solaire organique selon la revendication 1, dans laquelle une épaisseur de la couche reformée d'électrode (801) est de 5 nm ou plus et de 200 nm ou moins.

6. Procédé de fabrication d'une cellule solaire organique, le procédé comprenant les étapes consistant à :
préparer un substrat (101) ;
former une première électrode (201) sur le substrat ;
former une couche reformée d'électrode (801) sur la première électrode ;
former une couche de matière organique d'une ou plusieurs couches incluant une couche photoactive (601) sur la couche reformée d'électrode ; et
former une seconde électrode(301) sur la couche de matière organique,
dans lequel la couche reformée d'électrode présente une structure à une seule couche, **caractérisé en ce que** la couche de reformage d'électrode inclut un oxyde métallique et du MgF₂.

7. Procédé selon la revendication 6, dans lequel la couche d'oxyde métallique est formée en omettant un procédé de traitement thermique ou est formée en utilisant le procédé de traitement thermique à 50 °C ou plus et à 250 °C ou moins.
